Europäisches Patentamt

(19) European Patent Office

Office européen des brevets

(11) Numéro de publication: **0 125 160**
**B1**

(12) # FASCICULE DE BREVET EUROPÉEN

(45) Date de publication du fascicule du brevet:
**13.01.88**

(51) Int. Cl.⁴: **H 05 K 7/14,** H 05 K 7/18

(21) Numéro de dépôt: **84400722.9**

(22) Date de dépôt: **11.04.84**

(54) Aménagement d'appareil à cartes électroniques reliées par un BUS.

(30) Priorité: **15.04.83 FR 8306174**

(43) Date de publication de la demande:
**14.11.84 Bulletin 84/46**

(45) Mention de la délivrance du brevet:
**13.01.88 Bulletin 88/2**

(84) Etats contractants désignés:
**BE DE FR GB IT NL SE**

(56) Documents cité:
**EP-A-0 067 757**
**FR-A-2 411 438**
**FR-A-2 430 164**
**US-A-3 733 523**
**US-A-3 838 777**
**US-A-4 046 443**

(73) Titulaire: **LA TELEMECANIQUE ELECTRIQUE, 33
bis, avenue du Maréchal Joffre, F-92000 Nanterre
(FR)**

(72) Inventeur: **Oehlert, Yves, 44 rue A. Dufaure,
F-92500 Rueil (FR)**
Inventeur: **Neyroud, Jean, Les Petoits Nurianette,
F-38420 Domene (FR)**
Inventeur: **Joly, Jean Louis André, 87 rue
Condorcet, F-78800 Houilles (FR)**

(74) Mandataire: **Bouju, André, Cabinet Bouju 38
avenue de la Grande Armée, F-75017 Paris (FR)**

## Description

La présente invention concerne l'aménagement d'un appareil, tel qu'un appareil pour l'acquisition, le traitement et/ou la restitution de signaux numériques, du genre automate programmable, calculateur et système d'informatique industrielle, d'instrumentation ou de transmission, comprenant un bac dont le fond comporte au moins un circuit imprimé sur lequel des blocs de connexion portant chacun une rangée de connexions sont fixés du côté de l'intérieur du bac, des glissières alignées côte à côte selon deux parois opposées adjacentes au fond du bac, une extrémité de chaque glissière étant associée mécaniquement au fond du bac, des moyens pour positionner ladite extrémité de chaque glissière relativement au déplacement parallèle aux rangées de connexions et au déplacement transversal au fond du bac, et des cartes entrée/sortie montées côte à côte chacune de façon amovible entre deux glissières se faisant face, les cartes ayant sur un de leurs bords des fiches destinées à être insérées dans les blocs de connexion.

La présente invention concerne également un procédé pour réaliser cet aménagement.

Un aménagement du genre cité au début est connu d'amrès le EP-A-67 757, notamment Figure 3. Les glissières 72 pour la carte électronique 21 et sa plaque de protection 30 sont fixées par des vis 64 à un blindage interne 10 du fond du bac. Les rangées de connexion 18 sont accessibles aux contacts de la carte électronique par des lumières pratiquées à travers le blindage 10.

En cas de mouvements d'origine thermique, le circuit imprimé tend à se déplacer par rapport au blindage 10 qui n'a pas le même coefficient de dilation. Si le circuit imprimé est fixé rigidement au blindage, le circuit imprimé subit des containtes et des déformations qui lui sont préjudiciables. Si au contraire le circuit imprimé peut se déformer indépendamment du blindage et si les blocs 18 ont du jeu dans les lumières du blindage (mais rien de tout cela n'est décrit dans le document antérieur) alors vont apparaître dans l'interengagment entre la carte 21 et le bloc 18 des efforts se traduisant par des contraintes dans le circuit imprimé et dans la carte électronique retenue par ses glissières.

Le FR-A-2 430 164 décrit un aménagement semblable au précédent. Les cartes sont apparament montées à coulisse dans des glissières aménagées sur des parois du bac. Le circuit imprimé est fixé au bac par des éléments de fixation 66 engagées dans des trous. Comme dans l'une des hypothèses relatives au précédent aménagement connu, le circuit imprimé subit des efforts néfastes résultant de sa fixation rigide au bac.

Selon le FR-A-2 411 438 les cartes ne sont pas portées par des glissières et ne doivent donc tenir que par leur embrochage dans les blocs de connexion. Les cartes peuvent donc subir des déformations en flexion, sous l'effet de leur propre poids ou de vibrations. Le mode de fixation du circuit imprimé au fond du bac n'est pas décrit.

Le but de l'invention est ainsi de proposer un aménagment d'appareils à cartes électroniques dans lequel le circuit imprimé et les cartes soient à l'abri des contraintes mécaniquent dangereuses.

Suivant l'invention, l'aménagement est caractérisé en ce que l'aménagement comprend des moyens (21) pour guider le circuit imprimé (3) selon son propre plan relativement au fond du bac, et des moyens (24, 31) pour coupler en translation transversale aux rangées de connexions l'extrémité de chaque glissière (11) et le circuit imprimé (3) au voisinage du bloc de connexion (8) associé, et en ce que, du moins au voisinage du fond (2, 52) du bac (1), les glissières latérales (11) adjacentes ont entre elles un certain jeu et sont montées de façon à pouvoir se déplacer latéralement les unes par rapport aux autres.

Si le circuit imprimé est sujet à des mouvements d'ordre thermique, il a la possibilité de se déplacer dans son plan relativement au fond du bac. Dans le cas nettement le plus dangereux où le mouvement est transversal aux rangées de connexions, le circuit imprimé entraîne avec lui les glissières par l'intermédiaire des moyens de couplage. Compte tenu de leur jeu dans cette direction, les glissières peuvent suivre le mouvement imposé par le circuit imprimé. Ainsi, le circuit imprimé peut se déplacer sans contraintes et les cartes, entraînées par les glissières, restent sans effort en face des blocs de connexion.

L'invention supprime ainsi es flexions d'origine thermique dans le circuit imprimé, dans les cartes et dans les différentes jonctions de l'assemblage.

Selon un second aspect de l'invention, l'aménagement d'un appareil, tel qu'un appareil pour l'acquisition, le traitement et/ou la restitution de signaux numériques, du genre automate programmable, calculateur et système d'informatique industrielle, d'instrumentation ou de transmission, comprenant une armature en U comprenant une paroi de fond à deux bords opposés de laquelle sont fixés deux flancs; au moins un circuit imprimé monté au voisinage de la paroi de fond de manière que des blocs de connexion fixés au circuit imprimé et portant chacun une rangée de connexion soient apparents à l'intérieur du bac à travers des ouvertures de la paroi du fond, des glissières alignées côte à côte selon deux rangées opposées s'étendant entre les deux flancs, une extrémité de chaque glissière étant associée mécaniquement au fond du bac; des moyens pour positionner ladite extrémité de chaque glissière relativement au déplacement parallèle aux rangées de connexions et au déplacement transversal au fond du bac, et des cartes entrée/sortie montées côte à côte chacune de façon amovible entre deux glissières se faisant faço, les cartes ayant sur un de leurs bords des fiches destinées à être insérées dans les blocs de connexion, est caractérisé en ce que le circuit imprimé est monté avec liberté de mouvement relativement à la paroi du fond et en ce que, le long de chaque rangée de glissières et extérieurement auxdites rangées, au moins une traverse fixée par ses extrémités aux deux flancs coopère avec des moyens portés par les glissières pour maintenir celles-ci à l'encontre de tout déplacement en direction transversale à la paroi de fond tout en permettant le déplacement parallèlement à la paroi de fond.

Ainsi, les glissières se déplacent comme le leur demandent les cartes, elles-mêmes susceptibles de se déplacer en conséquence des mouvements d'origine thermique du circuit imprimé. Aucune contrainte d'origine thermique ne peut apparaître.

D'autres particularités et avantages de l'invention ressortiront encore de la description ci-après.

Aux dessins annexés donnés à titre d'exemples non limitatifs:
- la figure 1 est une vue en perspective d'un aménagement d'automate programmable pendant la mise en place des cartes entrée/sortie;
- la figure 2 est une vue partielle en perspective éclatée du fond de l'automate de la figure 1 et d'une glissière;
- la figure 3 est une vue en plan de la paroi interne du fond du bac;
- la figure 4 est une vue partielle du fond du bac équipé des glissières guide-carte, en coupe selon un plan tel que IV-IV de la figure 3;
- la figure 5 est une vue en perspective partielle du fond portant deux glissières opposées, et d'un boîtier porte-carte destiné à être mis en place entre ces deux glissières;
- la figure 6 est une vue partielle du fond en coupe selon un plan tel que VI-VI de la figure 3, la rangée de connexions y étant représentée schématiquement par un bloc plein;
- la figure 7 est une vue partielle du bac portant les glissières, en coupe selon un plan tel que VII-VII à la figure 3;
- la figure 8 est une vue analogue à une partie de la figure 7, montrant le déplacement des pieds des glissières dans un exemple de mouvement d'origine thermique;
- la figure 9 est une vue en perspective de la paroi interne à laquelle sont fixés les deux flancs;
- la figure 10 est une vue analogue à la figure 9, après mise en place du circuit imprimé;
- la figure 11 est une vue analogue à la figure 10, après mise en place des glissières;
- la figure 12 est une vue analogue à la figure 9 mais relative à un bac double;
- la figure 13 est une vue en élévation latérale d'une glissière double, avec coupe partielle du pied selon le plan XIII-XIII de la figure 16 et coupe partielle du sommet d'une des glissières selon le plan XIII-XIII de la figure 14;
- la figure 14 est une vue de face de la glissière double de la figure 13;

- les figures 15 et 16 sont des vues de dessous et respectivement de dessus de la glissière des figures 13 et 14;
- la figure 17 est une vue de face d'un automate programmable avec bac double;
- la figure 18 est une vue d'une variante de réalisation du bac à automate, en coupe selon un plan de séparation entre deux boîtiers; et
- la figure 19 est une vue partielle du guide-fil selon la flèche XIX de la figure 18.

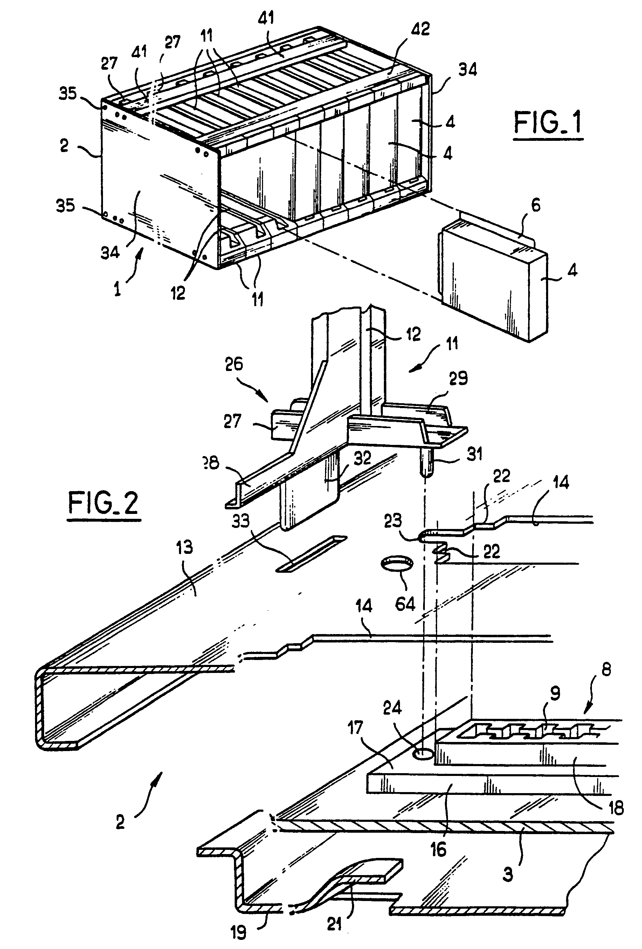

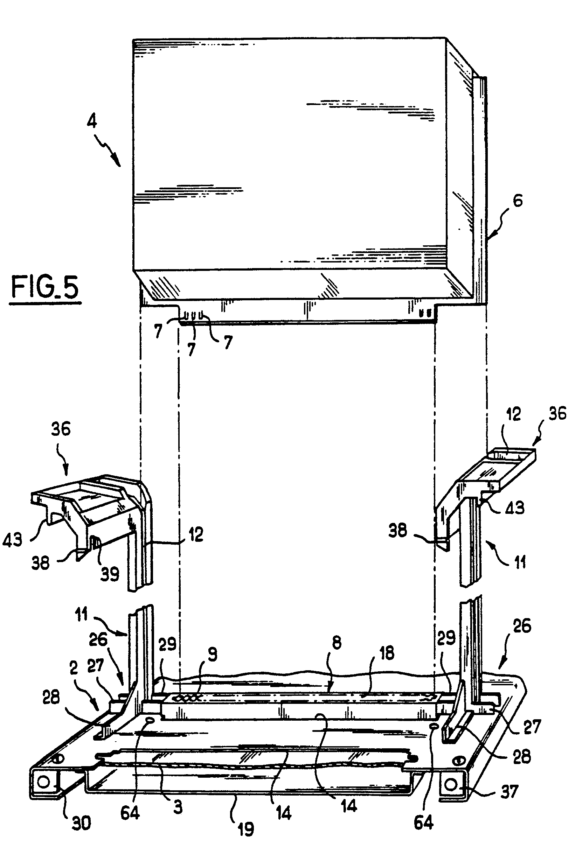

Comme le montre la figure 1, un automate programmable pris comme exemple d'appareil modulaire d'acquisition, de traitement et de restitution de signaux numériques, comprend dans son aménagement pratique, un bac 1 dont le fond 2, disposé verticalement, comporte un circuit imprimé 3 (figure 2). L'automate comprend encore des boîtiers 4 (figure 1) ranges verticalement côte à côte dans le bac 1. Chaque boîtier 4 comprend deux demi-boîtiers (non représentés) encliquetés ou vissés l'un avec l'autre avec interposition d'une carte entrée/sortie 6 qui fait saillie sur la face arrière du boîtier 4 et porte à cet emplacement des fiches mâles 7 (figure 5) destinées à venir s'enficher dans un bloc de connexion femelle 8 présentant une ouverture 9 capable d'accueillir le bord de la carte 6 muni des fiches 7 et renfermant une rangée de connexions femelles raccordées au circuit imprimé 3. Les blocs 8 sont fixés parallèlement les une aux autres sur la face du circuit imprimé 3 tournée vers l'intérieur du bac 1, chacun en face de l'un des emplacements pour les boîtiers 4.

Comme le montrent les figures 1 et 5, chaque carte 6 fait encore saillie latéralement de part et d'autre du boîtier 4 de façon à être en service engagée de façon amovible dans les fentes 12 de deux glissières 11 qui se font face dans le bac 1. Les glissières 11 sont montées selon deux parois latérales opposées du bac 1 adjacentes au fond 2.

Sur les dessins, les boîtiers 4 ont été représentés de façon très simplifiée, notamment leur face opposée au fond 2 du bac 1. Celle-ci est en effet aménagée d'une façon non représentée pour recevoir en service un bornier (non représenté également) destiné à relier la carte 6 aux appareillages à surveiller s'il s'agit d'une carte d'entrée ou à commander s'il s'agit d'une carte de sortie.

Conformément à l'invention, l'aménagement comprend une paroi interne 13 en tôle galvanisée (figures 2 à 6) qui est interposée entre le circuit imprimé 3 et l'intérieur du bac 1. La paroi interne 13 est plane à l'exception de ses deux bords longitudinaux (adjacents aux glissières 11) qui sont recourbés en U vers l'extérieur. La paroi interne comporte une série de lumières allongées 14 dont chacune est en face de l'un des blocs de connexion 8.

Comme le montre plus particulièrement la figure 2, le bloc de connexion 8 présente une embase 16 adjacente au circuit 3, le bloc étant ensuite rétréci par un épaulement 17 formant la face supérieure de l'embase 16 et entourant un bossage rectangulaire 18 dans lequel est pratiquée l'ouverture 9 contenant les connexions.

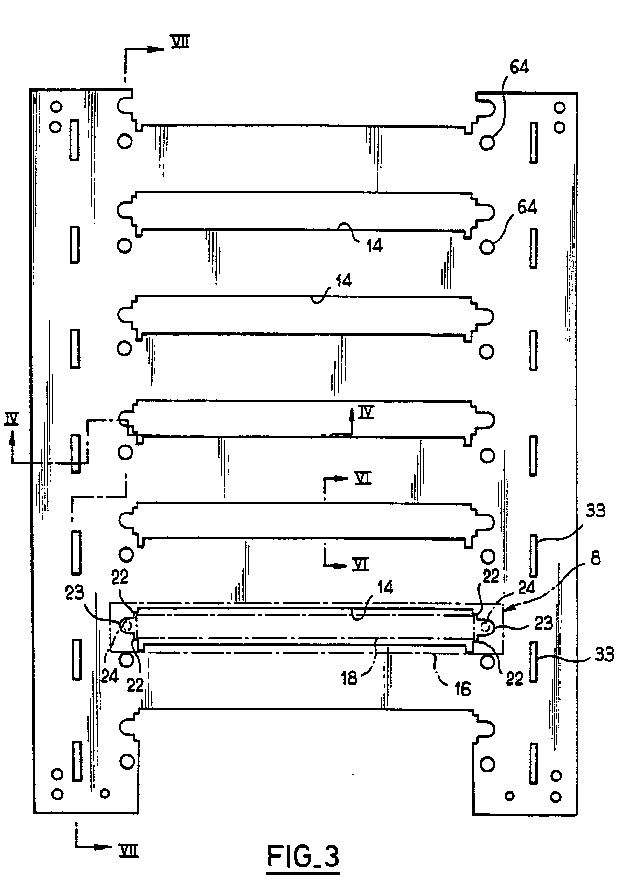

Comme représenté en trait mixte à la figure 3, chaque lumière 14 est plus petite que l'embase 16 des blocs 8 mais est plus grande que le bossage 18 de sorte que les bossages 18 font saillie à l'intérieur du bac 1 (figure 5) tandis que les embases 16 demeurent de l'autre côté de la paroi interne 13.

Le fond du bac 1 comprend encore un capot de blindage 19 (figure 2) qui est fixé par vissage à la paroi 13 et qui recouvre et protège le circuit du côté opposé a la paroi 13.

L'aménagement comprend aussi des moyens pour solliciter le circuit 3 vers la paroi 13 de façon que les épaulements 17 formant butée soient en appui contre celle-ci autour des lumières 14. Ainsi le circuit 3 est guidé dans son plan par rapport à la paroi 13, dans la limite du mouvement permis aux bossages 18 dans les lumières 14.

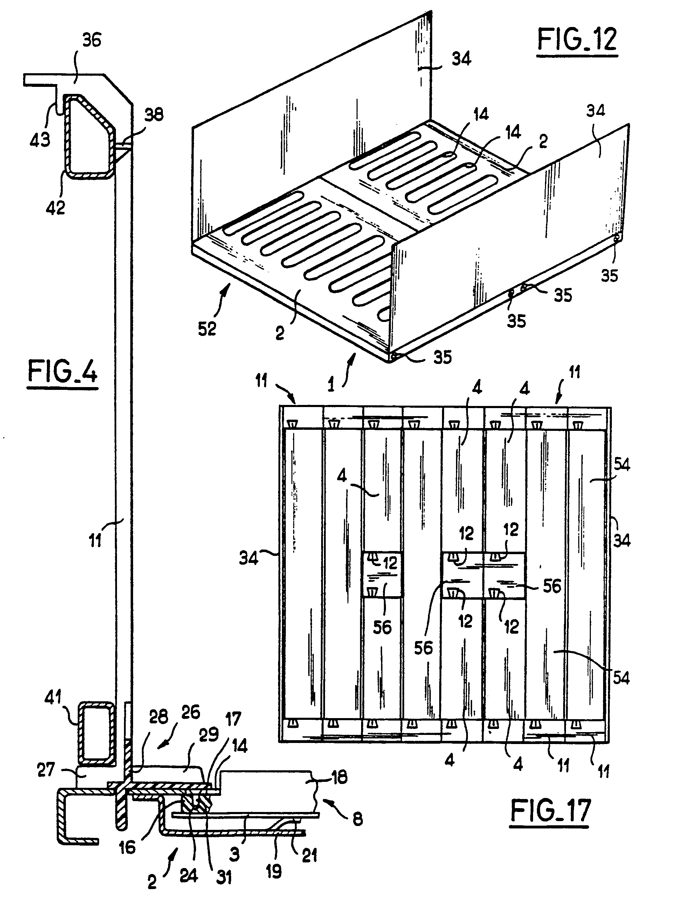

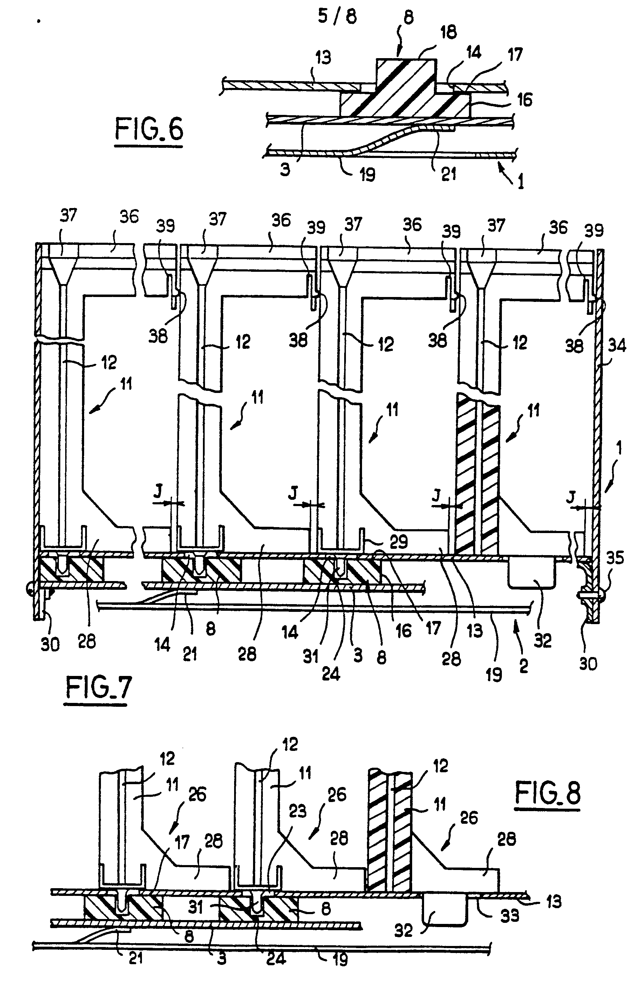

Dans l'exemple représenté, ces moyens sont constitués par des crevés pratiqués dans le capot 19 vers l'intérieur du bac, ces creves définissant des languettes élastiques 21 appuyées contre le circuit 3 (figures 4 et 6).

Comme le montre la figure 3, les lumières 14 ont un contour rectangulaire dont on n'aurait conservé que les quatre angles 22. Le rectangle ainsi défini par les quatre angles 22 est plus long et plus large que le rectangle du bossage 18. Le jeu longitudinal est calculé pour permettre une dilatation longitudinale éventuelle des blocs tout en assurant un positionnement assez précis du circuit imprimé 3 relativement à la paroi interne 13 selon la direction longitudinale des rangées de connexion. Ce sont seulement les lumières 14 coopérant avec les bossages 13 qui assurent un certain positionnement initial du circuit 3 relativement à la paroi 13.

En outre, le bossage 18 dispose d'un jeu latéral appréciable entre les quatre angles 22.

Comme on le verra plus loin, ce jeu a pour but de permettre au bossage 18 de se déplacer latéralement dans la lumière 14 en fonction des mouvements thermiques relatifs entre la paroi 13 et le circuit imprimé 3. Le jeu latéral est cependant limité pour assurer un positionnement aussi précis que possible du circuit 3 relativement à la paroi 13 malgré cette liberté de mouvement. Les jeux longitudinaux et latéraux ont en outre l'avantage d'assouplir les tolérances de fabrication.

Entre les quatre angles 22, chaque lumière 14 s'étend en dehors du rectangle défini par ceux-ci. A cet effet, les lumières 14 présentent selon leurs longueurs des découpes ayant pour but de faciliter encore les problèmes de précision à la fabrication. Selon leurs largeurs, les lumières 14 présentent des découpes à profil en U 23 découvrant à chaque extrémité de chaque lumière 14 un perçage 24 porté par l'épaulement 17 (figures 2 à 4).

Selon une particularité importante de l'invention, les perçages 24 font partie de moyens pour coupler en translation transversale aux rangées de connexions chaque extrémité d'un bloc de connexions 8 avec la glissière 11 associée.

Chaque glissière 11 comprend un pied 26 ayant trois aîles 27, 28, 29 dont les faces dirigées vers la paroi 13 forment un plan d'appui sur celle-ci. L'aîle 29 qui est en service dirigée vers le bloc 8 associé porte sur sa face inférieure un tenon 31 qui en service est engagé sensiblement sans jeu dans le perçage 24. L'aîle 28 dirigée perpendiculairement aux rangées de connexions porte sur sa face inférieure un tenon 32 aplati selon cette direction et engagé dans une fente 33, jouant le rôle de mortaise, qui traverse la paroi 13 et a une longueur appropriée pour laisser un jeu à chaque extrémité du tenon 32 (figure 7).

Les glissières 11 sont ainsi découplées du circuit imprimé 3 ou de la paroi 13 à l'égard des mouvements relatifs tendant à écarter les glissières de la paroi 13 transversalement à cette dernière.

Le bac 1 comprend deux flancs opposés 34 (voir figure 1) fixés parallèlement aux boîtiers 4 par des vis 35 à des pattes 30 elles-mêmes fixées aux extrémités des bords en U de la paroi intérieure 13 (figure 5).

Comme le montre la figure 7, la distance entre les flancs 34 permet d'y loger un certain nombre de glissières 11 en laissant chaque fois un certain jeu J (par exemple 0,5 mm) entre l'extrémité de l'aîle 28 d'une glissière 11 et la glissière 11 voisine.

A leur extrémité opposée à la paroi interne 13, les glissières 11 présentent une tête élargie 36 dans laquelle la fente 12 est évasée en un entonnoir 37 destiné à faciliter l'introduction des cartes 6. Le fait que les tenons 31 soient dans leur perçage 24 garantit que les fentes 12 des deux glissières 11 se faisant face et l'ouverture 9 du bloc de connexions 8 situé entre elles sont dans un même plan, si bien que les cartes 6 n'encourent aucune détérioration au cours de l'introduction.

La dimension des têtes élargies 36 dans le sens perpendiculaire au plan 34 est telle que les têtes 36 sont positionnées rigidement entre les flancs 34. Pour simplifier les problèmes de précision de fabrication, l'extrémité de chaque tête 36 s'appuie contre la glissière 11 voisine ou respectivement contre le flanc 34 par un bossage 38 derrière lequel est pratiquée une entaille 39 permettant au bossage 38 un certain mouvement élastique dans la direction perpendiculaire aux flancs 34, c'est-à-dire la direction parallèle au fond 2 du bac 1 et transversale aux rangées de connexions.

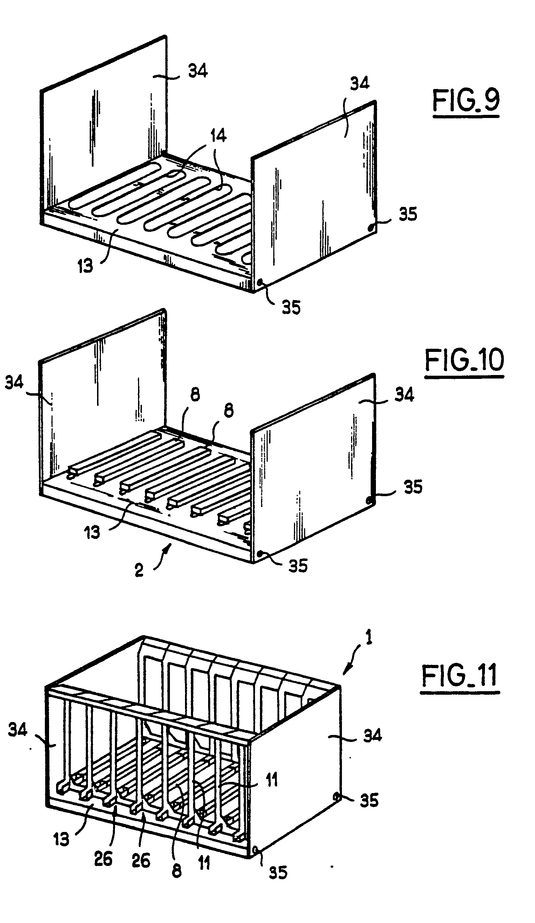

On va maintenant décrire en référence aux figures 9 à 11 le procédé d'assemblage de l'automate programmable: on commence par constituer une armature en U en fixant à la paroi interne 13 présentant ses lumières 14 les deux flancs 34 à l'aide des vis 35. Comme le montre la figure 10, on met ensuite en place sous la paroi 13 le circuit imprimé 3 dont les blocs de connexion 8 apparaissent ainsi par les lumières 14 et on met en place le capot de blindage 19.

Le fond 2 du bac, ainsi constitué, est placé horizontalement et on met en place une à une les glissières 11 qui forment les deux autres parois (à claire-voie) du bac 1.

Comme le montrent les figures 1 et 4 on monte ensuite contre et à l'extérieur de chaque paroi à claire-voie constituée par les glissières 11 une paire de traverses 41, 42. Chaque traverse 41, 42 s'étend de l'un à l'autre des flancs 34 et est fixée à ceux-ci. La traverse 41 est placée contre l'aîle 27 des pieds 26 qui est dirigée à l'opposé des blocs de connexion 8. La traverse 41 se trouve du côté de l'aîle 27 opposé à la paroi 13 et constitue ainsi un élément empêchant le mouvement des glissières 11 perpendiculairement à la paroi 13. De plus, la traverse 41 contraint le pied 26 à rester appuyés à plat contre la paroi 13 et empêche donc le basculement des glissières 11. Cependant, la distance libre entre la traverse 41 et la paroi 13 est suffisante pour permettre le déplacement de la glissière 11 parallèlement à la traverse 41 lorsque la glissière 11 est entraînée dans cette direction par le circuit imprimé 3.

L'autre traverse 42 est montée contre les têtes 36 des glissières 11 et est engagée derrière une lèvre 43 que présente chaque tête 36 en direction de la paroi 13. Les traverses 42 rigidifient le positionnement assuré par les traverses 41 en empêchant le déplacement des têtes 36 parallèlement aux rangées de connexions 8 dans les deux sens.

On peut ensuite mettre en place les boîtiers 4 entre les glissières 11 comme cela est représenté à la figure 1.

Comme le montre la figure 8 par comparaison avec la figure 7, lorsque le circuit imprimé 3 subit une contraction d'ordre thermique plus importante que la paroi interne 13, le bloc de connexion 8 de gauche étant supposé rester immobile, les blocs de connexion 8 des deux autres glissières 11 représentées tendent à réduire leur intervalle mutuel et à se rapprocher de celui de gauche. Par le couplage comprenant les perçages 24 et les tenons 31, le déplacement des blocs 8 entraîne celui du pieds 26 des glissières 11 correspondantes moyennant réduction du jeu entre les pieds 26. Au cours de son déplacement, le circuit imprimé 3 peut glisser sur les languettes 21 du capot 19 tandis que l'épaulement 17 des blocs 8 glisse sous la paroi interne 13. Le déplacement du pied 26 des glissières 11 ainsi entraînées est permis par les tenons aplatis 32 qui coulissent dans les fentes 33.

L'invention permet ainsi au circuit imprimé 3 de subir sans contrainte les mouvements d'origine thermique ou autre dont il peut être le siège même si ces mouvements sont différents de ceux des parties métalliques, et ceci est assuré sans pour autant que les glissières soient fixées au circuit imprimé et sans qu'il y ait risque que la fente 12 des glissières 11 ne soit pas coplanaire avec l'ouverture 9 des blocs de connexion 8.

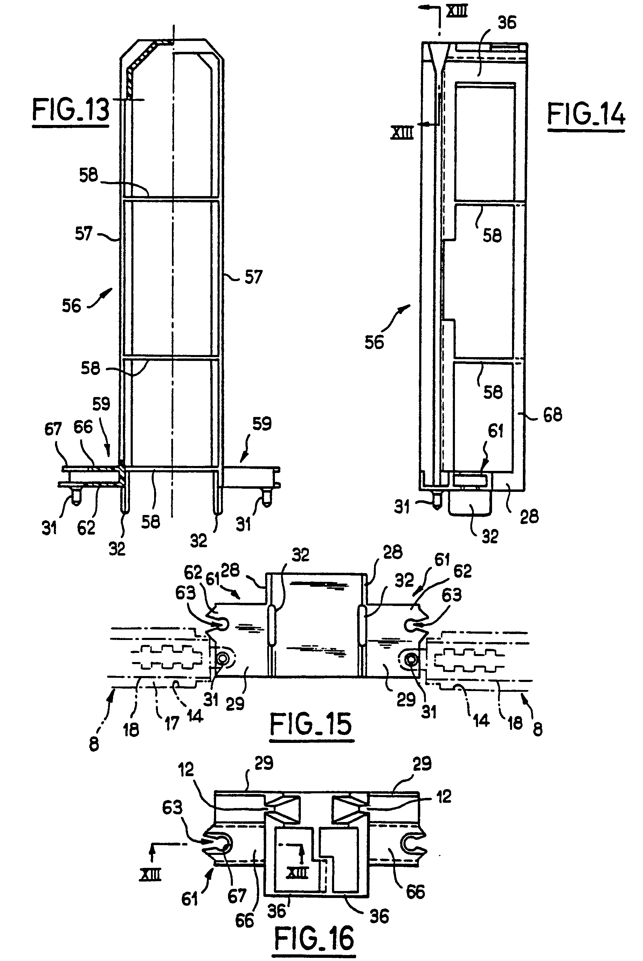

Dans l'exemple représenté à la figure 12, on part d'une armature en U qui est analogue à celle de la figure 9, excepté que le fond 52 du bac 1 est constitué de deux éléments modulaires 2 dont chacun est identique au fond 2 des figures 1 à 11, et que les flancs 34 ont relativement à ceux des figures 1 à 11 une dimension double mesurée parallèlement aux rangées de connexions. Les flancs 34 sont fixés aux deux éléments modulaires 2 par quatre vis 35 vissées dans les pattes 30 des deux éléments 2 et assurent ainsi que les éléments 2 sont fixés l'un à l'autre en étant accolés par l'un de leurs bords perpendiculaires aux rangées de connexion.

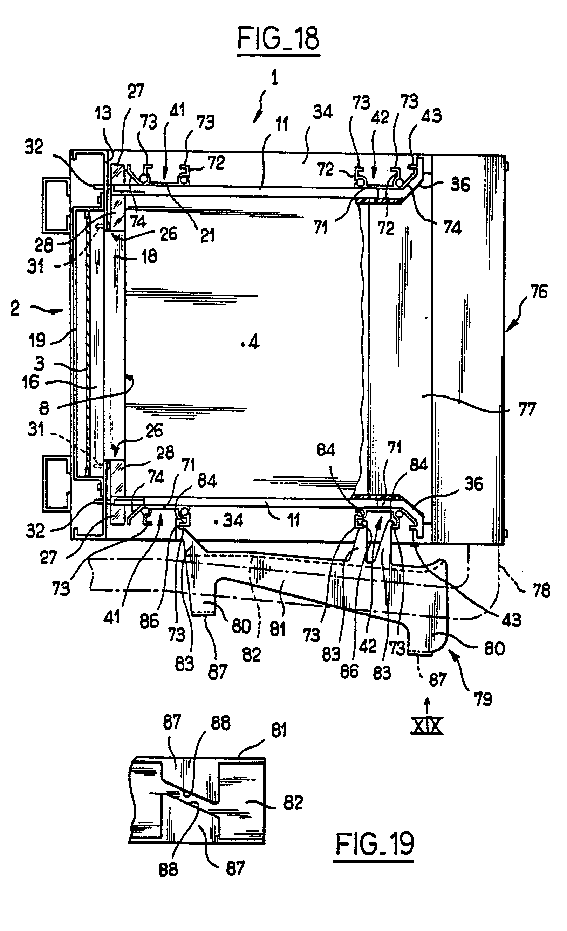

Comme le montre la figure 17, le bac double peut accueillir entre les glissières 11 formant ces parois latérales des boîtiers 54 dont la hauteur correspond à l'espacement entre les lesdites glissières 11. De tels boîtiers portent une carte entrée/sortie dont la largeur lui permet de coulisser dans deux glissières 11 se faisant face, et de coopérer avec deux blocs 8 alignés. Cependant, le bac peut accueillir des boîtiers 4 analogues à ceux des figures 1 à 11 et prévus pour ne coopérer qu'avec un seul des éléments 2 du fond. Il est alors possible de monter deux boîtiers 4 dans le même plan à la place qu'aurait pu occuper un seul boîtier 54.

A cet effet, l'invention prévoit de monter en chevauchement sur les bords accolés des deux éléments 2 une glissière double 56 présentant une fente 12 vers chacun des deux boîtiers 4 qui sont dans le même plan et qu'elle sépare.

Comme le montrent les figures 13 à 16, une glissière double 56 comprend deux glissières élémentaires 57 réunies en un seul bloc de matière synthétique moulée par des voiles 58. Chacune des glissières élémentaires 57 est analogue à une glissière 11 des figures 1 à 11 et en particulier, chaque glissière 57 a un pied 59 comprenant une aîle 29 portant un tenon 31 destiné à coopérer avec un perçage 24 d'un bloc de connexion 8 et une aîle 28 portant un tenon 32 destiné à être engagé dans une mortaise 33 de l'un des éléments de fond 2. Ainsi, chaque glissière double 56 coopère avec un perçage 24 et avec une fente 33 de chacun des éléments 2 qu'elle chevauche, grâce à un pied double formé par deux pieds 59.

Comme le montrent les figures 15 et 16, le pied de chaque glissière élémentaire 57 comprend encore une oreille 61 située dans l'angle entre les aîles 28 et 29 du pied 59. L'oreille 61 est réalisée sous forme tubulaire pour des questions de rigidité. Elle comporte un voile 62 qui en service est contre la paroi interne 13 de l'élément 2 adjacent et présente un perçage ouvert latéralement 63 permettant de fixer par vissage la glissière double 56 à chacun des éléments de fond 2 qui présente à cet effet un perçage taraudé 64 au voisinage de chaque extrémité longitudinale de chaque lumière 14 (figure 3). L'oreille 61 comprend encore un voile 66 parallèle au voile 62 et présentant une échancrure 67 pour permettre le vissage. Le perçage 63 a un diamètre supérieur à celui de la vis utilisée pour la fixation si l'on désire que la glissière double 56 puisse suivre les mouvements d'origine thermique ou autre des circuits imprimés 3 relativement aux parois internes 13 comme les glissières latérales 11. On peut également prévoir que les perçages 63 sont allongés parallèlement aux tenons 32.

Comme le montrent les figures 14 et 16, l'extrémité libre de la tête élargie 36 de chaque glissière élémentaire 57 est raccordée à l'extrémité libre du pied 59 par une colonne de renforcement 68 raccordée aux voiles 58.

Grâce aux glissières doubles 56 conformes à l'invention, il est possible comme le montre la figure 17, de disposer alternativement un boîtier double 54 et deux boîtiers de dimension élémentaire 4 selon une organisation dictée par les contingences de circuit, sans avoir à regrouper les boîtiers 4 d'un côté et les boîtiers 54 de l'autre.

Dans l'exemple de réalisation représenté aux figures 18 et 19 dont on ne décrira que les différences relativement à la réalisation des figures 1 à 11, les traverses 41 et 42 ont des profils identiques mais sont montées symétriquement l'un par rapport à l'autre.

Chaque traverse 41 ou 42 a un corps profilé en C dont une âme plane 71 est appuyée contre la glissière 11. Le corps profilé en C comprend encore deux ailes parallèles 72 dont les deux extrémités forment deux nervures 73 dirigées l'une vers l'autre. A l'un des bords de l'âme 71 est raccordée une aîle oblique 74 qui est située à l'extérieur du C et forme un angle d'environ 45° avec l'aîle 72 adjacente. A l'opposé de l'âme 71, l'aîle oblique 74 est coudée à 135° et présente ainsi une extrémité parallèle aux aîles 72.

L'aîle oblique 74, coudée à 135°, de chaque traverse 42 est appliquée contre des appuis de même profil que présente la tête 36 des glissières 11 du côté extérieur au bac 1. L'extrémité de l'aîle oblique 74 est engagée derrière la lèvre 43.

L'extrémité coudée à 135° de chaque traverse 41 est appliquée contre l'aîle 27 des pieds 26 des glissières 11.

On a représenté à la figure 18 un bornier 76 dont un fond 77 est emboîte dans le boîtier 4. De l'une des extrémités du bornier 76 part un faisceau de fils 78 pour la jonction avec les appareils à surveiller ou à commander, avec des sources d'énergie ou autres.

Les fils 78 sont ramenés vers le fond 2 du bac 1 et à cet effet ils sont engagés dans un guide-fils 79 ayant une forme de chenal avec deux parois latérales 81 reliées du côté du bac 1 par un fond 82. Il est prévu un bornier 76 et un guide-fils 79 pour chaque boîtier 4. Le fond 82 porte trois pattes élastiques 83 terminées par des becs 84 destinés à s'encliqueter sur les nervures 73 de la traverse 42 et sur la nervure 73 que porte la traverse 41 du côté de la traverse 42. Deux au moins des pattes 83 comportent en-deçà du bec 84 une encoche 86 destinée à accueillir la nervure 73 correspondante et empêcher les mouvements du guide-fil dans les deux sens transversalement au plan de la nervure 73.

Aux deux extrémités du guide-fil 79, chaque paroi latérale 81 porte des extensions 80 dirigées à l'oppose du fond 82 et portant à leur extrémité libre des pattes 87 dirigées l'une vers l'autre. Les bords libres 88 des pattes 87 sont sensiblement parallèles entre eux mais obliques relativement au plan longitudinal médian du guide-fil. Ils sont en outre séparés par une distance au moins égale au diamètre d'un fil du faisceau 78. Pour insérer les fils du faisceau 78 dans le guide-fil 79, on les courbe de façon à les faire passer entre les bords 88 des pattes 87. Une fois les fils connectés à leurs deux extrémités, l'obliquité du passage entre les bords 88 suffit à empêcher qu'ils sortent du guide-fil 79.

Bien entendu, l'invention n'est pas limitée aux exemples décrits et représentés, et de nombreux aménagements peuvent être apportés à ces exemples sans sortir du cadre de l'invention.

C'est ainsi que l'on pourrait prévoir que les glissières latérales 11 pourraient être associées directement à la paroi interne 13 de façon à coulisser relativement à celle-ci selon la direction perpendiculaire aux rangées de connexions, ce qui pourrait rendre inutile la traverse 41.

On peut aussi prévoir que le circuit 3 est fixé à la paroi 13 en un point ou selon une ligne de façon à donner au circuit 3 un positionnement initial fixe relativement à la paroi 13. Ceci n'empêcherait pas le circuit 3 de subir des mouvements d'origine thermique relativement à la paroi 13 à distance de cette fixation.

**Revendications**

1. Aménagement d'un appareil, tel qu'un appareil pour l'acquisition, le traitement et/ou la restitution de signaux numériques, du genre automate programmable, calculateur et système d'informatique industrielle, d'instrumentation ou de transmission, comprenant un bac (1) dont le fond (2, 52) comporte au moins un circuit imprime (3) sur lequel des blocs de connexion (8) portant chacun une rangée de connexions sont fixés du côté de l'intérieur du bac (1), des glissières (11) alignées côte à côte selon deux parois opposées adjacentes au fond (2, 52) du bac (1), une extrémité de chaque glissière (11) étant associée mécaniquement au fond du bac, des moyens (26, 32, 33, 41) pour positionner ladite extrémité de chaque glissière (11) relativement au déplacement parallèle aux rangées de connexions et au déplacement transversal au fond (2, 52) du bac (1), et des cartes entrée/sortie (6) montées côte à côte chacune de façon amovible entre deux glissières (11, 57) se faisant face, les cartes (6) ayant sur un de leurs bords des fiches (7) destinées à être insérées dans les blocs de connexion (8), caractérisé en ce que l'aménagement comprend des moyens (21) pour guider le circuit imprimé (3) selon son propre plan relativement au fond du bac, et des moyens (24, 31) pour coupler en translation transversale aux rangées de connexions l'extrémité de chaque glissière (11) et le circuit imprimé (3) au voisinage du bloc de connexion (8) associé, et en ce que, du moins au voisinage du fond (2, 52) du bac (1), les glissières latérales (11) adjacentes ont entre elles un certain jeu et sont montées de façon à pouvoir se déplacer latéralement les unes par rapport aux autres.

2. Aménagement conforme à la revendication 1, caractérisé en ce que les glissières (11) sont découplées du circuit imprimé (3) dans la direction perpendiculaire au fond (2, 52) du bac.

3. Aménagement conforme à l'une des revendications 1 ou 2, caractérisé en ce que les moyens pour guider le circuit imprimé comprennent des moyens (21) pour appliquer, par l'intermédiaire de butées d'appui (17), le circuit imprimé (3) contre une paroi interne (13) interposée entre le circuit imprimé (3) et l'intérieur du bac (1), et présentant des lumières (14) donnant accès aux blocs de connexion (8) depuis l'intérieur du bac.

4. Aménagement conforme à la revendication 3, et dont le fond (2, 52) comporte un capot de blindage (19) qui recouvre le circuit imprimé (3) à l'opposé de l'intérieur du bac, caractérisé en ce que le capot de blindage (19) porte les moyens (21) appliquant le circuit imprimé (3) contre la paroi interne (13) par l'intermédiaire des butées d'appui (17).

5. Aménagement conforme à la revendication 4, caractérisé en ce que les moyens appliquant le circuit imprimé (3) contre la paroi interne (13) par l'intermédiaire des butées d'appui (17) comprennent des crevés formant languettes élastiques (21), pratiqués dans le capot de blindage (19) en direction de la paroi interne (13).

6. Aménagement conforme à l'une des revendications 3 à 5, caractérisé en ce que les moyens de butée (17) sont portés par les blocs de connexion (8).

7. Aménagement comforme à la revendication 6, caractérisé en ce que les blocs (8) sont engagés dans les lumières (14) avec un certain jeu en direction transversale aux rangées de connexions, et en ce que certains au moins des blocs de connexion (8) comportent une embase (16) formant, à l'opposé du circuit imprimé (3), un épaulement (17) faisant partie des butées d'appui précitées et coopérant avec la paroi interne (13) au voisinage du pourtour des lumières (14).

8. Aménagement conforme à la revendication 7, caractérisé en ce que les lumières comprennent des bords (22) coopérant avec les blocs (8) pour assurer au circuit imprimé (3), dans les directions parallèles au plan de la paroi interne (13), un positionnement avec un certain jeu.

9. Aménagement conforme à l'une quelconque des, revendications 7 ou 8, caractérisé en ce que les moyens de couplage (24) de chaque bloc (8) sont portés par l'épaulement (17) du bloc (8) et chaque lumière (14) présente aux extrémités du bloc (8) des découpes (23) permettant le couplage avec la glissière associée (11).

10. Aménagement conforme à l'une quelconque des revendications 3 à 9, caractérisé en ce que chaque glissière (11) comporte un pied (26) qui, en service, est maintenu sensiblement en appui contre la paroi interne (13) du fond (2, 52) du bac (1) par les moyens (41) positionnant les glissières (11) à l'égard du déplacement en direction transversale au fond du bac, et en ce que l'aménagement comprend, entre chaque pied (26) de glissière (11) et le fond (2, 52) du bac (1), un guidage à tenon (32) et mortaise (33) transversal aux rangées de connexions.

11. Aménagement conforme à l'une quelconque des revendications 1 à 10, caractérisé en ce que, à l'opposé du fond (2) du bac (1), les glissières (11) sont positionnées de façon sensiblement rigide relativement au bac (1) dans la direction parallèle au fond (2, 52) du bac (1) et transversale aux rangées de connexions.

12. Aménagement conforme à la revendication 11, caractérisé en ce que les glissières (11) présentent, à l'opposé du fond (2) du bac (1), des têtes (36) dimensionnées pour être sensiblement en butée les unes contre les autres entre des moyens d'appui (34) solidaires du bac (1) lorsque toutes les glissières sont en place dans le bac (1).

13. Aménagement conforme à la revendication 12, caractérisé en ce que chaque glissière (11) porte, au voisinage de son extrémité opposée au fond (2, 52) du bac (1), un élément (38) qui assure, en service, le contact avec l'une des deux glissières (11) voisines et qui est déformable élastiquement dans la direction parallèle au fond (2, 52) du bac (1) et transversale aux rangées de connexions.

14. Aménagement conforme à l'une quelconque des revendications 1 à 13, caractérisé en ce que le fond (2, 52) du bac (1) a, dans la direction longitudinale des rangées de connexions, une dimension appropriée pour recevoir, au choix, des cartes d'entrée/sortie occupant sensiblement cette dimension ou bien des cartes d'entrée/sortie (6) pouvant être disposées au nombre d'au moins deux mises bout à bout dans cette direction, en ce que les glissières comprennent des glissières latérales (11) adjacentes aux parois d'extrémité et des glissières doubles (56) destinées à être montées chacune entre deux cartes d'entrée/sortie (6) mises bout à bout, les glissières doubles (56) présentant deux glissières élémentaires (57) disposées dos à dos, et étant liées au fond du bac (1) relativement au déplacement transversal à ce dernier.

15. Aménagement conforme à la revendication 14, caractérisé en ce que le fond (52) du bac (1) est constitué d'au moins deux éléments modulaires (2) accolés par un bord transversal aux rangées de connexions, chaque élément modulaire (2) portant un circuit imprimé (3) et, le long de chacun de ses bords transversaux aux rangées de connexions, des moyens (33) de positionnement pour les glissières latérales (11), et en ce que les glissières doubles (56) comportent un double pied (59) destiné à chevaucher les bords accolés des deux éléments modulaires adjacents (2) et aménagé de façon à coopérer avec les moyens de positionnement (33) portés par ces deux bords.

16. Aménagement conforme à la revendication 15, caractérisé en ce que chaque élément modulaire porte, au voisinage de chacun de ses bords, des moyens (64) destinés à coopérer avec un pied (59) de glissière double (56) de façon à immobiliser celle-ci à l'égard des mouvements perpendiculaires au fond du bac, et en ce que le pied double (59) de chaque glissière double (56) est adapté à coopérer ainsi avec chacun des bords accolés des éléments modulaires (2) qu'il chevauche.

17. Aménagement d'un appareil tel qu'un appareil pour l'acquisition, le traitement et/ou la restitution de signaux numériques, du genre automate programmable, calculateur et système d'informatique industrielle, d'instrumentation ou de transmission, comprenant une armature en U comprenant une paroi de fond (13) à deux bords opposés de laquelle sont fixés deux flancs (34); au moins un circuit imprimé (3) monté au voisinage de la paroi de fond de manière que des blocs de connexion (8) fixés au circuit imprimé (3) et portant chacun une rangée de connexions soient apparents à l'intérieur du bac (1), à travers des ouvertures de la paroi de fond; des glissières (11) alignées côte à côte selon deux rangées opposées s'étendant entre les deux flancs (34), une extrémité de chaque glissière (11) étant associée mécaniquement au fond du bac; des moyens (26, 32, 33, 41) pour positionner ladite extrémité de chaque glissière (11) relativement au déplacement parallèle aux rangées de connexions et au déplacement transversal au fond (2, 52) du bac (1), et des cartes entrée/sortie (6) montées côte à côte chacune de façon amovible entre deux glissières (11, 57) se faisant face, les cartes (6) ayant sur un de leurs bords des fiches (7) destinées à être insérées dans les blocs de connexion (8), caractérisé en ce que le circuit imprimé (3) est monté avec liberté de mouvement relativement à la paroi de fond (13) et en ce que, le long de chaque rangée de glissières (11) et extérieurement auxdites rangées, au moins une traverse (41) fixée par ses extrémités aux deux flancs (34) coopère avec des moyens portés par les glissières (11) pour maintenir celles-ci à l'encontre de tout déplacement en direction transversale à la paroi de fond (13) tout en permettant le déplacement parallèlement à la paroi de fond (13).

18. Aménagement conforme à la revendication 17, caractérisé en ce que certaines au moins des traverses (41) portent des moyens pour la fixation de guide-fils (79) destinés à recevoir des faisceaux de fils (78) connectés à des borniers (76) associés à certaines au moins des cartes entrée/sortie (6) à l'opposé du fond du bac.

19. Aménagement conforme à la revendication 18, caractérisé en ce que chaque guide-fil (79) comprend un élément en chenal (81, 82) dont l'ouverture est partiellement fermée par au moins deux pattes (87) dirigées l'une vers l'autre et portées chacune par l'une des parois latérales (82) du chenal, et présentant des bords libres (88) sensiblement parallèles entre eux et obliques relativement au plan horizontal médian du chenal (81, 82).

### Patentansprüche

1. Vorrichtung für einen Apparat von der Art eines programmierbaren Automaten, Rechners und Systems der industriellen Informatik, der Instrumentierung oder der Übertragung, z. B. für die Aquisition, Verarbeitung und/oder Wiedergabe von numerischen Signalen, die ein Gehäuse (1) enthält, dessen Boden (2, 52) wenigstens einen gedruckten Schaltkreis (3) aufweist, wobei Anschlußblöcke (8), die je eine Reihe von Anschlüssen tragen, auf der dem Inneren des Gehäuses (1) zugewandten Seite des gedrückten Schaltkreis befestigt sind, Gleitschienen (11), die nebeneinander in zwei gegenüberliegender, an dem Boden (2, 52) des Gehäuses (1) anliegender Wände ausgerichtet sind, wobei ein Ende jeder Gleitschiene (11) mechanisch mit dem Boden des Gehäuses verbunden ist, Mittel (26, 32, 33, 41) zum Positionieren des Endes einer jeder Gleitschiene (11), relativ zur parallel zu den Reihen von Anschlüssen gerichteten Verschiebung und zur quer zum Boden (2, 52) des Gehäuses (1) gerichteten Verschiebung, und Eingangs-/Ausgangskarten (6), die nebeneinander jeweils abnehmbar zwischen zwei einander zugewandten Gleitschienen (11, 57) angeordnet sind, wobei die Karten (6) auf einem ihrer Ränder Stecker (7) zum Einführen in die Anschlußblöcke (8) aufweisen, dadurch gekennzeichnet, daß die Vorrichtung Mittel (21) umfaßt, um die gedruckte Schaltung (3) entlang ihrer eigenen Ebene relativ zum Boden des Gehäuses zu führen, und Mittel (24, 31), um hinsichtlich Querverschiebung zu den Reihen von Anschlüssen das Ende jeder Gleitschiene (11) und den gedruckten Schaltkreis (3) in der Nähe des zugeordneten Anschlußblockes (8) miteinander zu koppeln, und daß wenigstens in der Nähe des Bodens (2, 52) des Gehäuses (1) die angrenzenden seitlichen Gleitschienen (11) untereinander ein gewisses Spiel haben und so angebracht sind, daß sich die einen hinsichtlich der anderen seitlich verschieben können.

2. Vorrichtung nach Anspruch 1, dadurch gekennzeichnet, daß die Gleitschienen (11) vom gedruckten Schaltkreis (3) in zum Boden (2, 52) des Gehäuses senkrechter Richtung entkoppelt sind.

3. Vorrichtung nach Anspruch 1 oder 2, dadurch gekennzeichnet, daß die Mittel zum Führen des gedruckten Schaltkreises Mittel (21), enthalten, um mittels Anschlägen (17) den gedruckten Schaltkreis (3) an eine Innenwand (13) anzudrücken, die zwischen dem gedruckten Schaltkreis (3) und dem Inneren des Gehäuses (1) liegt und Öffnungen (14) aufweist, die Zugang zu den Anschlußblöcken (8) vom Inneren des Gehäuses her gewähren.

4. Vorrichtung nach Anspruch 3, deren Boden (2, 52) eine Abschirmhaube (19) aufweist, die den gedruckten Schaltkreis (3) auf der dem Inneren des Gehäuses gegenüberliegenden Seite bedeckt, dadurch gekennzeichnet, daß die Abschirmhaube (19) die Mittel (21) trägt, die den gedruckten Schaltkreis (3) gegen die Innenwand (13) mittels der Anschläge (17) andrücken.

5. Vorrichtung nach Anspruch 4, dadurch gekennzeichnet, daß die Mittel, die den gedruckten Schaltkreis (3) gegen die Innenwand (13) mittels der Anschläge (17) andrücken, elastische Laschen (21) bildende Schlitze umfassen, die in der Abschirmhaube (19) in Richtung auf die Innenwand (13) angeordnet sind.

6. Vorrichtung nach einem der Ansprüche 3 bis 5, dadurch gekennzeichnet, daß die Anschläge (17) von den Anschlußblöcken (8) getragen werden.

7. Vorrichtung nach Anspruch 6, dadurch gekennzeichnet, daß die Blocke (8) durch die Öffnungen (14) mit einem gewissen Spiel in Querrichtung zu den Reihen von Anschlussen ragen, und dass wenigstens gewisse Anschlußblöcke (8) eine Bodenplatte (16) tragen, die auf der dem gedruckten Schaltkreis (3) gegenüberliegenden Seite eine Schulter (17) bildet, der einen Teil der oben erwähnten Anschläge darstellt und der mit der Innenwand (13) angrenzend an den Rand der Öffnungen (14) zusammenwirkt.

8: Vorrichtung nach Anspruch 7, dadurch gekennzeichnet, daß die Öffnungen Ränder (22) umfassen, die mit den Blöcken (8) zusammenwirken, um für den gedruckten Schaltkreis (3) in den zur Ebene der Innenwand (13) parallelen Richtungen eine Positionierung mit einem gewissen Spiel sicherzustellen.

9. Vorrichtung nach einem der Ansprüche 7 oder 8, dadurch gekennzeichnet, daß die Kupplungsmittel (24) jedes Blockes (8) von der Schulter des Blockes (8) getragen werden und jede Öffnung (14) an den Enden des Blockes (8) Ausschnitte (23) aufweist, die das Kuppeln mit der zugeordneten Gleitschiene (11) zulassen.

10. Vorrichtung nach einem der Ansprüche 3 bis 8, dadurch gekennzeichnet, daß jede Gleitschiene (11) einen Fuß (26) aufweist, der im Betrieb im wesentlichen gegen die Innenwand (13) des Bodens (2, 52) des Gehäuses (1) durch die Mittel (41) in Anlage gehalten wird, die die Gleitschienen (11) hinsichtlich der Verschiebung in Querrichtung zum Gehäuseboden festlegen und daß die Vorrichtung zwischen jedem Fuß (26) der Gleitschiene (11) und dem Boden (2, 52) des Gehäuses (1) einen Führungszapfen (32) und einen Schlitz (33) quer zu den Reihen von Anschlüssen umfaßt.

11. Vorrichtung nach einem der Ansprüche 1 bis 10, dadurch gekennzeichnet, daß auf der dem Boden (2) des Gehäuses (1) gegenüberliegenden Seite die Gleitschienen (11) im wesentlichen fest relativ zum Gehäuse (1) hinsichtlich der zum Boden (2, 52) des Gehäuses (1) parallelen den Reihen von Anschlüssen quer liegenden Richtung positioniert sind.

12. Vorrichtung nach Anspruch 11, dadurch gekennzeichnet, daß die Gleitschienen (11) auf der dem Boden (2) des Gehäuses (1) gegenüberliegenden Seite Kopfteile (36) aufweisen, die so dimensioniert sind, daß sie sich im wesentlichen gegeneinander zwischen mit dem Gehäuse (1) zusammenhängenden Stützen (34) abstutzen wenn alle Gleitschienen in dem Gehäuse (1) angeordnet sind.

13. Vorrichtung nach Anspruch 12, dadurch gekennzeichnet, daß jede Gleitschiene (11) angrenzend an ihr Ende, das dem Boden (2, 52) des Gehäuses (1) gegenüberliegt, ein Element (38) trägt, das im Betrieb den Kontakt mit einem von den zwei benachbarten Gleitschienen (11) sicherstellt und das in der Richtung parallel zum Boden (2, 52) des Gehäuses (1) und quer zu den Reihen von Anschlüssen elastisch verformbar ist.

14. Vorrichtung nach einem der Ansprüche 1 bis 13, dadurch gekennzeichnet, daß der Boden (2, 52) des Gehäuses (1) in Längsrichtung der Reihen von Anschlüssen eine Abmessung hat, die geeignet ist, um wahlweise Eingangs-/Ausgangskarten aufzunehmen, die im wesentlichen diese Abmessung besitzen oder Eingangs-/Ausgangskarten (6), wovon wenigstens zwei paarweise in dieser Richtung aneinanderstoßend angeordnet werden können, und daß die Gleitschienen seitliche, an die Endwände angrenzende Gleitschienen (11) und doppelte Gleitschienen (56) umfassen, die zwischen je zwei aneinanderstossenden Eingangs-/Ausgangskarten (6) angebracht werden, wobei die doppelten Gleitschienen (56) zwei einfache Rücken an Rücken angeordnete Gleitschienen (57) aufweisen, und am Boden des Gehäuses (1) relativ zur Querverschiebung mit diesen verbunden sind.

15. Vorrichtung nach Anspruch 14, dadurch gekennzeichnet, daß der Boden (52) des Gehäuses (1) wenigstens aus zwei modularen Elementen (2) besteht, die durch einen quer zu den Reihen von Anschlüssen verlaufenden Rand zusammengefügt werden, wobei jedes modulare Element (2) einen gedruckten Schaltkreis (3) und längs jedes seiner quer zu den Reihen von Anschlüssen verlaufenden Rändern Positionierungsmittel (33) für die seitlichen Gleitschienen (11) trägt, und daß die doppelten Gleitschienen (56) einen doppelten Fuß (59) aufweisen, der die zusammengefügten Ränder der zwei modularen, angrenzenden Elemente (2) übergreift und so gestaltet ist, daß er mit dem durch diese zwei Ränder getragenen Positionierungsmittel (33) zusammenwirkt.

16. Vorriichtung nach Anspruch 15, dadurch gekennzeichnet, daß jedes modulare Element angrenzend zu jedem ihrer Ränder Mittel (64) trägt, die mit einem Fuß (59) der doppelten Gleitschiene (56) derart zusammenwirken, daß dieser hinsichtlich der zum Gehäuseboden senkrechten Bewegungen unbeweglich gemacht wird, und daß der doppelte Fuß (59) jeder doppelten Gleitschiene (56) so angepaßt ist, daß er mit jedem der zusammengefügten Ränder der modularen Elemente (2), die er übergreift, zusammenwirkt.

17. Vorrichtung für einen Apparat von der Art eines programmierbaren Automaten, Rechners und Systems der industriellen Informatik, der Instrumentierung oder der Übertragung, z. B. für die Aquisition, Verarbeitung und/oder wiedergabe von numerischen Signalen, die eine U-förmige Armatur mit einer Bodenwand (13) enthält, die an zwei gegenüberliegenden Rändern zwei an ihr befestigte Flansche (34) aufweist, wenigstens einen gedruckten Schaltkreis (3), der angrenzend an die Bodenwand so angebracht ist, daß Anschlußblöcke (8), die am gedruckten Schaltkreis (3) befestigt sind, und von denen jeder eine Reihe von Anschlüssen trägt, zum Inneren des Gehäuses (1) hin durch Öffnungen der Bodenwand hindurch zugänglich sind; Gleitschienen (11), die nebeneinander in zwei gegenüberliegenden Reihen aufgereiht sind, die sich zwischen den zwei Flanschen (34) erstrecken, wobei ein Ende jeder Gleitschiene (11) mechanisch mit dem Gehäuseboden verbunden ist; Mittel (26, 32, 33, 41) zum Positionieren des Endes jeder Gleitschiene (11) relativ zur parallel zu den Reihen von Anschlüssen gerichteten Verschiebung und zur quer zum Boden (2, 52) des Gehäuses gerichteten Verschiebung, und Eingangs-/Ausgangskarten (6), die nebeneinander jeweils abnehmbar zwischen zwei einander zugewandten Gleitschienen (11, 57) angeordnet sind, wobei die Karten (6) auf einem ihrer Ränder Stecker (7) zum Einführen in die Anschlußblöcke (8) aufweisen, dadurch gekennzeichnet, daß der gedruckte Schaltkreis (3) mit Bewegungsfreiheit relativ zur Bodenwand (13) angebracht ist und daß längs jeder Reihe von Gleitschienen (11) und außerhalb dieser Reihen wenigstens eine Querleiste (41), die an ihren Enden an den zwei Flanschen (34) befestigt ist, mit Mittel zusammenwirkt, die von den Gleitschienen (11) getragen werden, um diese gegen jede Verschiebung in Querrichtung zur Bodenwand (13) aufrechtzuerhalten, wobei sie die Verschiebung parallel zur Bodenwand (13) stets zuläßt.

18. Vorrichtung nach Anspruch 17, dadurch gekennzeichnet, daß wenigstens einige Querleisten (41) Mittel zur Befestigung von Kabelführungen (79) tragen, die Kabelbunde (78) aufnehmen, welche mit Anschlusskasten (76) verbunden sind, die mit wenigstens einige Eingangs-/Ausgangskarten (6) auf derer dem Gehäuseboden gegenüberliegenden Seite zugeordnet sind.

19. Vorrichtung nach Anspruch 18, dadurch gekennzeichnet, daß jede Kabelführung (79) ein rillenförmiges Element (81, 82) umfaßt, dessen Öffnung teilweise durch wenigstens zwei Laschen (87) verschlossen ist, die gegeneinander gerichtet sind, und jeweils durch eine der Seitenwände (82) der Rinne getragen sind und die freie Ränder (88) aufweisen, die zueinander im wesentlichen parallel und relativ zur Längsmittelebene der Rinne (81, 82) schräg verlaufen.

**Claims**

1. An arrangement of an apparatus, such as an apparatus for the acquisition, processing and/or restitution of digital signals, of the type comprising a programmable auto-control, computer or system of industrial data-processing, instrumentation or transmission, comprising a container (1), the bottom (2, 52) of which possesses at least one printed circuit (3), on which connecting blocks (8) each carrying a row of connections, are fastened towards the interior of the container (1), slides (11) aligned side by side along two opposite walls which are adjacent to the bottom (2, 52) of the container (1), one end of each slide (11) being associated mechanically with the container bottom, means (26, 32, 33, 41) of positioning the said end of each slide (11) as regards displacement parallel to the rows of connections and as regards displacement transverse to the bottom (2, 52) of the container (1), and input/output cards (6) which are removably mounted side by side, each between two opposing slides (11, 57), the cards (6) having on one of their edges pins (7) adapted to be inserted into the connecting blocks (8), characterized in that the arrangement comprises means (21) for guiding the printed circuit (3) in its own plane relative to the container bottom, and means (24, 31) for coupling, as to translation transverse to the rows of connections, the end of each slide (11) and the printed circuit (3) in the vicinity of the associated connecting block (8), and in that at least in the vicinity of the bottom (2, 52) of the container (1), the adjacent lateral slides (11) have a certain play between them and are mounted so at to be laterally displaceable relative to one another.

2. An arrangement as claimed in claim 1, characterized in that the slides (11) are uncoupled from the printed circuit (3) in the direction perpendicular to the bottom (2, 52) of the container.

3. An arrangement as claimed in one of claims 1 or 2, characterized in that the means of guiding the printed circuit comprise means (21) of laying the printed circuit (3) via bearing stops (17) against an inner wall (13) which is interposed between the printed circuit (3) and the interior of the container (1) and has apertures (14) giving access to the connecting blocks (8) from the interior of the container.

4. An arrangement as claimed in claim 3, the bottom (2, 52) of which has a screening cover (19) which covers the printed circuit (3) on the side thereof facing away from the interior of the container, characterized in that the screening cover (19) carries the means (21) laying the printed circuit (3) against the inner wall (13) via the bearing stops (17).

5. An arrangement as claimed in claim 4, characterized in that the means laying the printed circuit (3) against the inner wall (13) via the bearing stops (17) comprise slashes which form elastic tabs (21) and which are made in the screening cover (19) towards the inner wall (13).

6. An arrangement as claimed in one of claims 3 to 5, characterized in that the stop means (17) are carried by the connecting blocks (8).

7. An arrangement as claimed in claim 6, characterized in that the blocks (8) are engaged in the apertures (14) with a certain play in the direction transverse to the rows of connections, and in that at least some of the connecting blocks (8) possess a base (16) which forms, on the side thereof facing away from the printed circuit (3), a shoulder (17) belonging to the above-mentioned bearing stops and interacting with the inner wall (13) in the vicinity of the periphery of the apertures (14).

8. An arrangement as claimed in claim 7, characterized in that the apertures have edges (22) interacting with the blocks (8) to ensure that the printed circuit (3) is positioned with a certain play in the directions parallel to the plane of the inner wall (13).

9. An arrangement as claimed in either one of claims 7 or 8, characterized in that the means (24) of coupling each block (8) are carried by the shoulder (17) of the block (8), and each aperture (14) possesses at the ends of the block (8) cutouts (23) allowing coupling to the associated slide (11).

10. An arrangement as claimed in any one of claims 3 to 8, characterized in that each slide (11) has a foot (26) which, during operation, is maintained for substantially resting against the inner wall (13) of the bottom (2, 52) of the container (1) by the means (41) positioning the slides (11) as regards displacement in the direction transverse to the bottom of the container, and in that the arrangement comprises, between each foot (26) of a slide (11) and the bottom (2, 52) of the container (1), a means of guidance by tenon (32) and mortise (33) transverse to the rows of connections.

11. An arrangement as claimed in any one of claims 1 to 10, characterized in that, remote from the bottom (2) of the container (1), the slides (11) are positioned substantially rigidly relative to the container (1) in the direction parallel to the bottom (2, 52) of the container (1) and transverse to the rows of connections.

12. An arrangement as claimed in claim 11, characterized in that the slides (11) possess, remote from the bottom (2) of the container (1), heads (36) of such dimensions as to be substantially in abutment against one another between bearing means (34) stationary with respect to the container (1), when all the slides are installed in the container (1).

13. An arrangement as claimed in claim 12, characterized in that each slide (11) carries, in the vicinity of its ends remote from the bottom (2, 52) of the container (1), an element (38) which, during operation, ensures contact with one of the two adjacent slides (11) and which is elastically deformable in the direction parallel to the bottom (2, 52) of the container (1) and transverse to the rows of connections.

14. An arrangement as claimed in any one of claims 1 to 13, characterized in that the bottom (2, 52) of the container (1) has, in the longitudinal direction of the rows of connections, a suitable dimension for receiving either input/output cards substantially occupying this dimension or alternatively input/output cards (6) which can be arranged end to end in this direction in numbers of at least two, and in that the slides comprise lateral slides (11) adjacent to the end walls and double slides (56), wherein each double slide is adapted to be mounted between two input/output cards (6) placed end to end, and wherein the double slides (56) have two elementary slides (57) arranged back to back and are connected to the bottom of the container (1) as regards displacement transverse to the latter.

15. An arrangement as claimed in claim 14, characterized in that the bottom (52) of the container (1) consists of at least two modular elements (2) joined together by means of an edge transverse to the rows of connections, each modular element (2) carrying a printed circuit (3) and, along each of its edges transverse to the rows of connections, positioning means (33) for the lateral slides (11), and in that the double slides (56) possess a double foot (59) adapted to straddle the joined edges of both adjacent modular elements (2) and arranged so as to interact with the positioning means (33) carried by these two edges.

16. An arrangement as claimed in claim 15, characterized in that each modular element carries, in the vicinity of each of its edges, means (64) intended for interacting with a foot (59) of a double slide (56), so as to immobilize the latter in respect of movements perpendicular to the bottom of the container, and in that the double foot (59) of each double slide (56) is designed to interact in this way with each of the joined edges of the modular elements (2) which it straddles.

17. An arrangement of an apparatus, such as an apparatus for the acquisition, processing and/or restitution of digital signals, of the type comprising a programmable auto-control, computer or system of industrial data-processing, instrumentation or transmission, comprising a U-shaped framework comprising a bottom wall (13) and two flanks (34) secured to two opposed edges of said bottom wall; at least one printed circuit (3) mounted in the vicinity of said bottom wall so that connecting blocks (8) secured to the printed circuit (3) and carrying each a row of connections appear inside the container (1) through apertures of the bottom wall; slides (11) aligned side by side in two opposed rows extending between the flanks (34), wherein one end of each slide is mechanically associated with the bottom of the container; means (26, 32, 33, 41) for positioning said end of each slide (11) as regards displacement parallel to the rows of connections and displacement transverse to the bottom (2, 52) of the container (1), and input/output cards (6) removably mounted side by side, each card between two slides (11, 57) facing eachother, wherein the cards (6) have on one of their edges pins (7) for insertion into the connecting blocks (8), characterized in that the printed circuit (3) is mounted with a freedom of displacement with respect to the bottom wall (13) and in that, along each row of slides (11), and outside with respect to said rows, at least one cross-member (41) secured by the two ends thereof to the two flanks (34) cooperates with means carried by the slides (11) for maintaining said slides against any displacement in a direction transverse to the bottom wall (13) while allowing displacement parallel to the bottom wall (13).

18. An arrangement according to claim 17, characterized in that at least some of the crossmembers (41) carry means of fastening wire guides (78) which are adapted to receive bunches of wires (78) connected to terminal-boxes (76) associated with at least some of the input/output cards (6) in a location remote from the bottom of the container.

19. An arrangement as claimed in claim 18, characterized in that each wire guide (79) comprises a gutter-shaped element (81, 82), the aperture of which is partially closed by at least two lugs (87) which are directed towards one another and are each carried by one of the side walls (82) of the gutter and which have free edges (88) substantially parallel to one another and oblique relative to the longitudinal center plane of the gutter (81, 82).

FIG. 1

FIG. 2

FIG_3

FIG.12

FIG.4

FIG.17

FIG.5

5 / 8

FIG.6

FIG.7

FIG.8

FIG.9

FIG.10

FIG.11

FIG.13

FIG.14

FIG.15

FIG.16

## FIG_18

## FIG_19